# EUROPEAN PATENT APPLICATION

(11) **EP 2 626 650 A2**
(43) Date of publication of application: **14.08.2013**
(21) Application number: 10807591.2
(22) Date of filing: 07.10.2010
(51) Int. Cl.: F24J 2/12, G02B 5/02, H01L 31/052, G02B 27/09, F24J 2/06, F24J 2/15

(54) **SOLAR RECEIVER FOR SOLAR CONCENTRATION SYSTEMS COMPRISING LIGHT HOMOGENIZATION**

(71) Applicant: Renovalia Energy, S.A., 28006 Madrid (ES)
(72) Inventor: ORTEGA MARTINEZ, Juan Domingo, E-28006 Madrid (ES)
(74) Representative: Elosegui de la Pena, Inigo
(86) International application number: PCT/ES2010/070645
(87) International publication number: WO 2012/045895

(57) **Abstract**

Receiver that homogenises light in a solar concentration system, in such a way that the concentrated light incidental upon a receiver has a homogeneous distribution, meaning that even in the event of the distribution of the light concentrated on the focal point of the parabola not having a homogeneous distribution, thanks to the disposition of a diffuser in front of the receiver said uniformity is achieved; additionally and with a view to achieving improved uniformity between the diffuser and the receiver a low-losses light guide is provided. Thanks to this system it is possible not to be so precise in the construction of the parabolas, furthermore achieving the receivers' maximum possible performance.

## Description

### OBJECT OF THE INVENTION

The invention, as stated in the title of the invention, relates to a receiver for solar concentration systems with light homogenisation, which allows a uniform distribution of light on the solar receiver even when using primary optics with a non-perfect distribution of the concentrated light.

The present invention is characterised by the special configuration and design of its materials and parts in order to achieve a very good optical light distribution on solar receivers such as multi-cell CPV systems, steam generators, gas heaters, among others.

The present invention is circumscribed to the field of electro generation based on sunlight, and particularly to the field of photovoltaic and thermal concentration systems.

### BACKGROUND OF THE INVENTION

To date solar concentration systems employ high efficiency photovoltaic cells, which have a performance of more than 20%. Given that high efficiency solar cells are connected in series and that the production of each one depends on the solar radiation received, it is indispensable for all of the cells to receive sunlight as homogenously as possible, because otherwise the receiver consisting of several high efficiency solar cells arranged in series, would be limited to the solar cell having the least production, in other words, to the one that receives the least sunlight, hence the need on the part of all high efficiency solar cells to receive as homogenously as possible.

With a view to achieving said uniformity in the solar radiation over the entire surface of the receiver different concentration systems have been developed which seek to achieve a uniform radiation on the receiver.

One of the solutions adopted is the use of very high precision primary optics, which entails a very high cost.

Another of the adopted solutions is the use of optics systems consisting of a multiplicity of small-sized reflectors, with dimensions such that they try to achieve a reflection of the size of the receiver, and pursue homogenisation by means of superimposing the reflections of each reflector on the receiver.

This solution makes it compulsory to have a primary optic made up of a large number of parts. Furthermore, each reflector must be perfectly oriented so that following the superposition of the reflections, the light on the receiver is as homogenous as possible. This is only achieved in the central zones of the receiver, where all the reflections supposedly ought to be superimposed, however, in the perimeter zones of the receiver the incidence of the sun is clearly less, meaning that a homogenous incidence of light on all of the high efficiency cells is not achieved, which clearly reduces the result obtained, in any situation.

In the systems of electrical production using solar concentration systems associated to thermal means of production such as for example a Stirling engine, the homogeneity in the application of the heat source is fundamental.

A Stirling engine performs work through the expansion and contraction of a gas (normally helium, hydrogen, nitrogen or even air) as it is forced to follow a cooling cycle at a cold source, whereupon it contracts, and a heating cycle at a hot source, whereupon it expands.

The temperatures that can be reached in the focal points of the solar concentration parabolas are very high, meaning that in the case of a lack of homogeneity in the application of the heat source, not all parts of the heat source or thermal motor heads are subjected to the same temperature, which is a cause of thermal stress, with a greater deterioration of some parts than of others.

Also, with the objective of achieving a homogenous application of the heat sources to the gas contained inside the thermal motors complex systems have been developed that seek to achieve the homogeneous application of the heat source to the gas.

With a view to achieving uniform heat source application different methods have been developed, such as the one described in patent US 6487859, which discloses a hybrid high temperature solar receiver which among other particularities has means for the uniform distribution of heat over the tubes.

However, for solar concentration systems wherein light is used as the means of production it has not been possible to develop any means that allows for achieving a uniform application of solar radiation in a uniform manner.

In the light of all of the above, it is clear that in both solar concentration systems for production by means of photovoltaic cells and in solar concentration systems for energy production by thermal means it is essential to achieve a uniform and homogeneous application of the solar radiation concentrated on the receiver, whether photovoltaic or thermal.

Consequently, the object of the present invention is to develop a receiver that allows application of concentrated solar radiation on a receiver in a uniform manner across the entire surface of the receiver.

### DESCRIPTION OF THE INVENTION

The object of the invention is a receiver for concentrated solar energy which achieves homogenisation of the concentrated solar radiation before it is applied to receiver. The receiver is disposed above the focal point of a parabola and on which the sunlight coming from a parabola is reflected in a concentrated manner.

The receiver consists of:
- an optical diffuser
- a receiver of concentrated sunlight, already homogenised which can contain among others, photovoltaic cells, systems for heating solids, liquids or gases, including phase change of the receiver's materials.

An optical diffuser is any device that diffuses, spreads or distributes light in a soft and uniform way once the light crosses the diffuser, and can be made of different materials, such as standard glass, ^{®} Pirex, fused silica, synthetic quartz or sapphire, the latter being employed in the case of higher temperatures. Also, to manufacture the diffuser it is possible to use any other material that offers similar optical properties to those of the diffusers made of the materials mentioned in the first place.

The diffusers are requested to have zero first order transmissions.

In the case of photovoltaic solar concentration systems and with a view to achieving an improved uniformity or homogeneity of the light in its incidence on the receiver, in this case high efficiency photovoltaic solar cells, it is possible to place a light guide between the diffuser and the receiver.

The homogeneity achieved is greater the greater the length of the light guide and it is considered that with an incidence ratio of four reflections per ray complete homogeneity is achieved.

The geometry and dimensions of the light guide can be any, adapted to the geometry of the receivers.

In the event of using a parabolic trough formed by a multiplicity of mirrors as a concentration system, the sunlight reflected and concentrated by this primary optic would present a non-uniform light distribution over the entire surface of the receiver and optionally geometries that do not coincide with the geometry of the receiver, meaning that it would become necessary to carry out a homogenisation of the intensity of the light that reaches the surface of the receiver and optionally a modification of the geometry of the light distribution, for example from a circle to a square.

In order to achieve the objectives of uniformity, the receiver has a diffuser which is used to "break" the light in such a "fine" way that it achieves a maximum homogeneity of the solar intensity over a geometry, mainly circular, although it may vary according to the geometry of the primary optic. If the geometry of the receiver is similar to the required geometry, or the homogenisation of the light over the receiver does not have to be excessively accurate (this tends to be the case in heating systems), by placing the diffuser at a suitable distance from the receiver, the required effect is achieved.

If furthermore, it is desirable to achieve a change in geometry or a very high homogenisation, a light guide is used, having the required geometry, which helps to channel the light and to make it even more uniform after its passage through the diffuser and before it reaches the receiver. Ideally, the light guide is made up of a figure having the required geometry and sufficient length, which is mirrored with as much reflectivity as possible in order to minimise losses.

The longer the light guide, the more the achieved light homogenisation over the receiver, but in exchange there are greater losses due to optical reflections on the light guide.

Depending on the application, there may be a multitude of designs. For the case of photovoltaic concentration solar receivers with multiple cells (or "dense" receivers) a system with average reflections of between 1 and 4 is considered ideal, given that it balances the homogenisation of the light with the losses. Of course the optical efficiency of the primary optic is an element to be considered in selecting the length of the light guide.

Due to the fact that it is possible for the temperature reached in the receiver to be very high, optionally all or some of the elements of the system can be cooled by means of natural convection systems such as dissipators, by means of forced cooling systems using a gas or forced air, or by forced cooling using a fluid such as water.

Therefore, thanks to the receiver with means for homogenisation of the concentrated light, several very important effects are achieved:
- On the one hand, the so-called shadow effect is avoided, in other words, the effect that occurs when a concentrator partially shadows the concentration parabola of an adjoining concentrator, meaning that the ray concentrated on the receiver would in no way whatsoever have a homogenous distribution, and now, thanks to the disposition of the diffuser a uniform distribution is achieved, meaning that the concentrators can be even closer together without fear of the so-called shadow effect.
- On the other hand, if the reflector glass disposed on the concentration parabola are not oriented with optimum precision, in principle nothing would happen, since it would be the diffuser itself, and if applicable and available the light guide, which take charge of homogenising the concentrated ray. This aspect is very important, as the deviations that occur in reflected rays are very important when the glass is not mounted with extreme accuracy. In general, these glass panes are secured using either screws, or are glued, which can introduce defects in the orientation of the optic and completely deviate the ray reflected from the focal point of the parabola.

- In the case of thermal solar applications, the thermal stress to which heating heads may be subjected is avoided.
- Another benefit resulting from the use of diffusers, further to the already explained light homogenisation, is the fact that the diffusers act as a means of protection, and therefore in the systems used to date above the photovoltaic cells a glass pane is disposed as a means of protection. At the same time this glass entails losses, and tends to be subjected to an anti-reflection treatment, meaning that with the use of the diffusers the need to have a means of protection of the photovoltaic cells is avoided.

### EXPLANATION OF THE DRAWINGS

In order to complement the description made below and with a view to contributing to a better understanding of its characteristics, a set of plans is attached to the present description whose figures, in an illustrative and non-limiting manner, represent the most significant details of the invention.
- fig. 1: shows a representation of a photovoltaic solar concentration system wherein the receiver of the invention has been disposed above the focal point of the parabola.
- fig. 2: shows a representation of a receiver and of the elements it comprises.
- fig. 3: shows a close-up of the receiver with the homogenisation means, in a possible mode of embodiment wherein it is possible to appreciate a directional nozzle for air to cool the diffuser.

### PREFERRED EMBODIMENT OF THE INVENTION

In the light of the figures what follows is a description of a preferred mode of embodiment of the proposed invention.

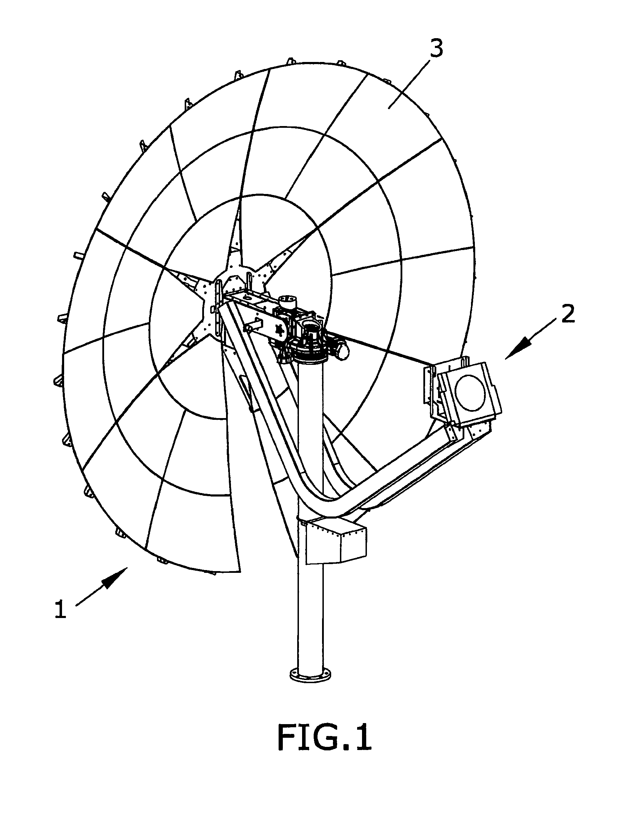

Figure 1 shows a solar concentrator where it is important to note the concentration parabola (1) on which a multiplicity of reflecting mirrors (3) are disposed, which reflect light on the focal point of the parabola where a homogenisation receiver (2) has been disposed, such as the one of the invention.

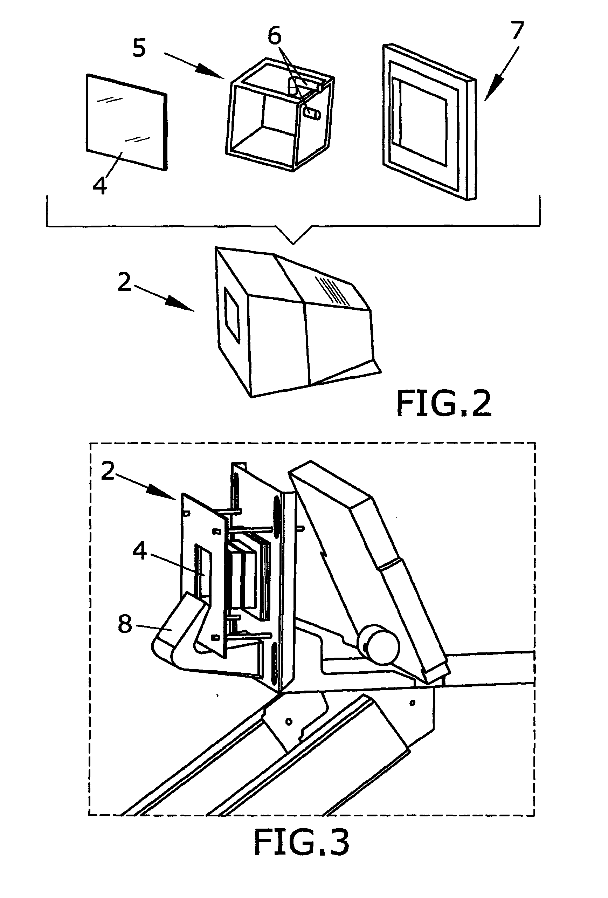

In Figure 2, which shows a possible mode of embodiment, it is possible to observe a receiver (2) and the elements it comprises, observing from left to right, that in the first place there is a diffuser (4), followed by a light guide (5), and next the support (7) for the high efficiency cells.

The diffuser (4) is used to "break" the light and achieve maximum homogeneity on the receiver. The diffusers can be made of various materials, but ideally the greatest possible light transmission is pursued, with the lowest possible transmission of first order light, in other words, the rays of light cross the diffuser with the lowest possible losses, but changing direction in a random manner as they cross it. An ideal material for the diffuser for high concentration systems is fused silica, which has the following properties:
Strain point: 990°C
Annealing point: 1100°C
Softening point: 1710°C
Coefficient of thermal expansion: 0.54 x 10⁻⁶/°C

However, other materials such as glass, quartz, sapphire and plastic materials can be used depending on the maximum operating temperature, concentration and distribution of the light and cost.

The light guide (5), which as mentioned above is not a necessary element and may not be present in either photovoltaic solar concentration systems or in thermal solar concentration systems, can have various geometrical shapes for example the shape of a square tunnel as shown in the figure, helps to channel the light and to make it even more uniform after it passes through the diffuser and before it reaches the receiver, normally presents a very high reflectivity mirroring and the lowest possible average number of reflections in order to achieve the required homogenisation.

In a possible mode of embodiment, and in the event of cooling being carried out by means of a liquid, the light guide (4) presents the shape of two square tunnels one inside the other, closed along the outer edges and which present inlet and outlet connections (5) for a cooling liquid, which once introduced in the space defined between the two square tubes runs through channels made to this effect.

In Figure 3 one can see how the receiver (2) to avoid heating of the diffuser (4) has a forced air cooling system with a view to evacuating the heat generated in the diffuser, carried out by means of a directional nozzle (8), with the stream of air acting directly on the outer surface of the diffuser (4), an action that in addition to cooling serves as a means of cleaning.

It is important to point out that the geometry of the light guide, diffuser and the form of cooling explained is non-limiting, with it being possible to use other geometries and forms of cooling such as by forced air or any other that achieves the purpose of reducing the temperature reached in the guide and in the support of the very high efficiency cells.

The essence of the invention is not modified by variations in materials, shape size or disposition of its components, described in a non-limiting fashion, in a manner sufficient for its reproduction by a person skilled in the art.

## Claims

1. Receiver for solar concentration systems **characterised in that** it carries out a homogenisation of concentrated incidental light having for this purpose:
• an optical diffuser
• a receiver of already homogenised concentrated solar light

2. Receiver for solar concentration systems, according to claim 1 **characterised in that** between the diffuser (4) and the receiver (7) a light guide (5) is placed which helps to channel the light and make it more uniform after it passes through the diffuser and before it reaches the receiver.

3. Receiver for solar concentration systems, according to claim 2, **characterised in that**, the light guide (4) presents the shape of two square tunnels one inside the other, closed off on the outer edges and that presents inlet and outlet connections (5) for a cooling liquid, which once introduced in the space defined between the two square tubes, runs through channels made for this purpose.

4. Receiver for solar concentration systems, according to claim 3, **characterised in that** inside the guide (5) an average number of reflections of between 1 and 4 are produced.

5. Receiver for solar concentration systems, according to claim 1, **characterised in that** the diffuser is made of any high transparency material such as glass, crystal, quartz, Sapphire, plastic, or any other material that offers the same optical properties as a diffuser made with the preceding materials.

6. Receiver for solar concentration systems, according to claim 5, **characterised in that** in the event of the diffuser being made of fused silica it has the following properties:
Strain point: 990°C
Annealing point: 1100°C
Softening point: 1710°C
Coefficient of thermal expansion: 0.54 x 10⁻⁶/°C

7. Receiver for solar concentration systems, according to claim 1, **characterised in that** the diffuser in order to prevent its overheating, has a cooling system by forced air with a view to evacuating the heat generated in the diffuser, performed by means of at least one directional nozzle (8).

8. Receiver for solar concentration systems, according to claim 1, **characterised in that** the receiver of homogenised sunlight are photovoltaic cells.

9. Receiver for solar concentration systems, according to claim 1, **characterised in that** the homogenised sunlight receiver are systems for heating solids, liquids or gases, including phase change of the receiver materials.
